# EUROPEAN PATENT SPECIFICATION

(11) **EP 3 604 473 B1**
(45) Date of publication and mention of the grant of the patent: **28.04.2021**
(21) Application number: 18775866.9
(22) Date of filing: 28.03.2018
(51) Int. Cl.: C09J 201/00, C09J 9/02, C09J 11/04, C09J 11/06, C09J 167/00, H01B 1/22, H01L 21/52, C08K 3/08, C08G 65/00, H01L 23/00

(54) **ELECTROCONDUCTIVE ADHESIVE COMPOSITION**
ELEKTRISCH LEITFÄHIGE KLEBSTOFFZUSAMMENSETZUNG
COMPOSITION ADHÉSIVE ÉLECTROCONDUCTRICE

(30) Priority: 31.03.2017 JP 2017072959
(43) Date of publication of application: 05.02.2020
(73) Proprietor: Tanaka Kikinzoku Kogyo K.K., Chiyoda-ku Tokyo 100-6422 (JP)
(72) Inventor: KOBORI, Koyo, 118259 (SG); IMAI, Yoshito, 118259 (SG); ABE, Shintaro, 118259 (SG); KONDO, Takeshi, Hiratsuka-shi Kanagawa 254-0021 (JP)
(74) Representative: Hoffmann Eitle
(86) International application number: PCT/JP2018/013058
(87) International publication number: WO 2018/181625

(56) References cited:
- EP-A1- 2 669 348
- JP-A- H 067 989
- JP-A- H09 204 816
- JP-A- H09 501 197
- JP-A- H11 269 443
- JP-A- 2008 110 391
- JP-A- 2008 110 391
- JP-A- 2015 193 865
- JP-A- 2015 193 865
- US-A- 5 637 176
- US-A- 5 667 899

## Description

### Technical Field

The present invention relates to an electroconductive adhesive composition.

### Background Art

Nowadays, there is a rapidly growing demand for electronic components having reduced sizes and advanced functions, e.g., power devices and light-emitting diodes (LEDs).

Power devices are spreading as semiconductor elements capable of highly efficiently performing power conversion while reducing power loss, in the field of electric vehicles, hybrid vehicles, quick chargers, etc. An increasing demand for power devices is being expected also in the field of new energy, such as photovoltaic power generation systems and mega-solar systems.

Meanwhile, LED elements, which have advantages of long life, small size, and low power consumption as compared with incandescent lamps, are spreading rapidly in various fields including the fields of illuminators, cell phones, liquid-crystal panels, motor vehicles, traffic signals, street lamps, and image display devices.

In the trend toward size reduction and function advancement in electronic components such as those mentioned above, the quantity of heat generated by those semiconductor elements tends to increase. However, through long-term exposure to high-temperature environments, electronic components become unable to perform the intrinsic functions and come to have a shortened life.

Because of this, bonding materials having high heat dissipation properties are usually used as bonding materials for die bonding (die bonding materials) in order to efficiently diffuse the heat generated by the semiconductor elements. Bonding materials are usually required to have the function of efficiently transferring the heat generated by the semiconductor elements to the substrates or housings, i.e., to have high heat dissipation properties, depending on applications.

Since the bonding materials for electronic components are required to have high heat dissipation properties, high-temperature lead solders, which contain lead in a large amount, and gold-tin solders, which contain gold in a large amount, have hitherto been used extensively. The high-temperature lead solders, however, have a problem in that the solders contain lead, which is harmful to the human body. Nowadays, techniques for eliminating the lead are hence being developed enthusiastically and investigations regarding switching to lead-free solders are being made actively. The gold-tin solders, on the other hand, are problematic because of the inclusion of expensive gold.

Under such circumstances, isotropic electroconductive adhesives (hereinafter referred to simply as "electroconductive adhesives") are nowadays attracting attention as a promising substitute for the high-temperature lead solders and the gold-tin solders. The electroconductive adhesive is a composite of metal particles having functions including electrical conductivity (e.g., silver, nickel, copper, aluminum, or gold) with an organic adhesive having adhesive function (e.g., an epoxy resin, silicone resin, acrylic resin, ester resin, or urethane resin), and various kinds of metal particles and organic adhesives are used. Such electroconductive adhesives are easy to use because the adhesives are liquid at room temperature, and are lead-free and inexpensive. The electroconductive adhesives are hence a promising substitute for the high-temperature lead solders and gold-tin solders, and are expected to be remarkably increasingly used in the market.

Patent Document 1 discloses an adhesive paste which includes an organic polymer resin, an inorganic filler, e.g., silver, and an easy-to-remove liquid and in which the particle diameters of the resin and filler and the solubility of the resin and liquid are not larger than given values.

Patent Document 2 describes a solder paste composition which comprises a solder alloy powder and a flux. The flux comprises, as a lubricant, a nonionic fluorinated surfactant obtained by adding ethylene oxide to a fluorine-containing compound with a specified structure.

Patent Document 3 describes a conductive adhesive composition including conductive particles containing a metal having a melting point of equal to or lower than 210°C; a resin having a softening point of equal to or lower than the melting point of the metal of the conductive particles and being solid at room temperature; a flux activator; and a solvent.

Patent Document 4 describes a method of making a heat-bondable, anisotropically electroconductive adhesive material using an adhesive mixture to form electroconductive bodies. In the method, 0.5 % to 2.0 % by weight based on the resin content of a fluorosurfactant may be added to the adhesive mixture.

Patent Document 5 describes a metal material containing metal particles, a solvent consisting of an organic solvent and a fluorine-based dispersant.

Patent Document 6 describes an electrically conductive bonding film consisting essentially of a self-supporting resin film, wherein the resin film comprises a specific polyimide resin and an electrically conductive filler. In the production of the conductive bonding film, the polyimide resin may be dissolved in an organic solvent followed by the addition of the conductive filler.

### Prior Art Document

### Patent Document

Patent Document 1: JP-T-H9-501197 (The term "JP-T" as used herein means a published Japanese translation of a PCT patent application.)
Patent Document 2: JP2008 110391 A
Patent Document 3: EP 2 669 348 A1
Patent Document 4: US 5 637 176 A
Patent Document 5: JP 2015 193865 A
Patent Document 6: US 5 667 899 A

### Summary of the Invention

### Problem that the Invention is to Solve

In the case where a powder of a thermoplastic resin such as an ester resin is used in an electroconductive adhesive, use of a polar solvent therewith is prone to result in dissolution of powdery resin and formation of a film barrier. There is hence a possibility that the volatilization rate, at which the solvent is removed from the bonding line, might become excessively low. It is hence necessary to use a nonpolar solvent in electroconductive adhesives employing a powdery ester resin containing a hardener.

However, in the case of using a nonpolar solvent, a phenomenon called bleeding-out occurs in which after die bonding with the electroconductive adhesive, the nonpolar solvent bleeds out from the adhesive, depending on the surface state of the adherends. Once the bleeding-out has occurred, this is causative of wire bonding failures during wire bonding, which is a later step in semiconductor design, or separation between the molding material and the substrate.

Accordingly, an object of the present invention is to provide an electroconductive adhesive composition which contains a thermoplastic resin and has high heat dissipation properties and which is inhibited from suffering the bleeding-out phenomenon in which a nonpolar solvent undesirably bleeds out after die bonding.

### Means for Solving the Problem

The present inventors diligently made investigations in order to accomplish the object. As a result, the inventors have discovered that an electroconductive adhesive composition containing a nonpolar solvent can be made controllable with respect to substrate-wetting properties by further incorporating a water-insoluble fluorochemical surfactant thereinto and that the bleeding-out phenomenon can be inhibited thereby. The present invention has been thus completed.

The present invention is as follows.
1. An electroconductive adhesive composition comprising: (A) electroconductive particles; (B) a thermoplastic resin; (C) a nonpolar solvent; and (D) a water-insoluble fluorochemical surfactant, wherein the electroconductive adhesive composition contains fluorine in an amount of at least 40 mass ppm of the whole electroconductive adhesive composition, the thermoplastic resin (B) is a saturated ester resin, and the nonpolar solvent (C) comprises one or more aliphatic or aromatic hydrocarbons.
2. The electroconductive adhesive composition according to above 1, wherein the water-insoluble fluorochemical surfactant (D) has a fluorine content of 20-70% by mass.
3. The electroconductive adhesive composition according to above 1 or 2, wherein the water-insoluble fluorochemical surfactant (D) is a fluorochemical surfactant having a perfluoroalkyl group.
4. The electroconductive adhesive composition according to any one of above 1 to 3, wherein the water-insoluble fluorochemical surfactant (D) is an ethylene oxide adduct having a perfluoroalkyl group.
5. The electroconductive adhesive composition according to any one of above 1 to 4, wherein the water-insoluble fluorochemical surfactant (D) is an oligomer compound having a perfluoroalkyl group.
6. The electroconductive adhesive composition according to any one of above 1 to 5, wherein the electroconductive particles (A) are powdery metallic particles comprising Ag or Cu as a main component.

### Effect of the Invention

The present invention can provide an electroconductive adhesive composition which has high heat dissipation properties and stable electrical conductivity and is inhibited from suffering bleeding-out after die bonding.

### Modes for Carrying Out the Invention

The electroconductive adhesive composition (hereinafter often referred to simply as "adhesive composition") of the present invention includes (A) electroconductive particles, (B) a thermoplastic resin, (C) a nonpolar solvent, and (D) a water-insoluble fluorochemical surfactant as essential components, as stated above. The adhesive composition of the invention is an adhesive composition which contains a thermoplastic resin (B) and has high heat dissipation properties and which, due to the inclusion of a water-insoluble fluorochemical surfactant (D), can be inhibited from suffering the bleeding-out phenomenon, in which a nonpolar solvent (C) bleeds out.

The present invention provides, as another embodiment, an electroconductive adhesive composition for bleeding-out inhibition, which includes (A) electroconductive particles, (B) a thermoplastic resin, (C) a nonpolar solvent, and (D) a water-insoluble fluorochemical surfactant. This invention is based on the finding that a water-insoluble fluorochemical surfactant can inhibit the bleeding-out phenomenon in which nonpolar solvents bleed out.

The electroconductive particles (A), thermoplastic resin (B), nonpolar solvent (C), and water-insoluble fluorochemical surfactant (D) are explained below in detail.

The electroconductive particles (A) in the invention are not particularly limited so long as the electroconductive particles are an ingredient which contributes to the electrical conductivity of the electroconductive adhesive. Preferred of such ingredients are metals, carbon nanotubes, and the like.

Usable metals are powders of metals which are generally handled as conductors. Examples thereof include elemental metals such as silver, copper, gold, nickel, aluminum, chromium, platinum, palladium, tungsten, and molybdenum, alloys each composed of two or more of these metals, materials coated with these metals, oxides of these metals, and satisfactorily electroconductive compounds of these metals.

More preferred of these are metals including silver or copper as a main component because such metals are less apt to oxidize and are high in thermal conductivity. The term "main component" herein means the component which is the highest in content among the components of the electroconductive particles.

The shape of the electroconductive particles is not particularly limited, and examples thereof include powdery, spherical, flaky, scaly, and dendritic shapes. In general, flaky or spherical particles are selected. The electroconductive particles can be commercially available ones, or can be produced by a conventionally known method. The method for producing the electroconductive particles is not particularly limited, and any desired method can be used, such as, for example, a mechanical pulverization method, reduction method, electrolytic method, or vapor-phase method.

The surface of the electroconductive particles may have been coated with a coating material, as stated above. Examples include coating materials including one or more carboxylic acids. By using a coating material including a carboxylic acid, the heat dissipation properties of the adhesive composition can be further improved.

The carboxylic acids contained in the coating material are not particularly limited. Examples thereof include monocarboxylic acids, polycarboxylic acids, and oxycarboxylic acids.

Examples of the monocarboxylic acids include aliphatic monocarboxylic acids having 1-24 carbon atoms, such as acetic acid, propionic acid, butyric acid, valeric acid, caprylic acid, caproic acid, capric acid, lauric acid, myristic acid, palmitic acid, stearic acid, arachidic acid, behenic acid, and lignoceric acid. Also usable are unsaturated aliphatic carboxylic acids having 4-24 carbon atoms, such as oleic acid, linolic acid, α-linolenic acid, γ-linolenic acid, dihomo-γ-linolenic acid, elaidic acid, arachidonic acid, erucic acid, nervonic acid, stearidonic acid, eicosapentaenoic acid, and docosahexaenoic acid. Furthermore, aromatic monocarboxylic acids having 7-12 carbon atoms, such as benzoic acid and naphthoic acid, and the like can be used.

Examples of the polycarboxylic acids include: aliphatic polycarboxylic acids having 2-10 carbon atoms, such as oxalic acid, malonic acid, succinic acid, glutaric acid, adipic acid, azelaic acid, and sebacic acid; aliphatic unsaturated polycarboxylic acids having 4-14 carbon atoms, such as maleic acid, fumaric acid, itaconic acid, sorbic acid, and tetrahydrophthalic acid; and aromatic polycarboxylic acids such as phthalic acid and trimellitic acid.

Examples of the oxycarboxylic acids include: aliphatic hydroxymonocarboxylic acids such as glycolic acid, lactic acid, oxybutyric acid, and glyceric acid; aromatic hydroxymonocarboxylic acids such as salicylic acid, oxybenzoic acid, and gallic acid; and hydroxypolycarboxylic acids such as tartaric acid, citric acid, and malic acid.

A higher fatty acid having 10 or more carbon atoms or a derivative of the acid can be incorporated into the coating material to be used for treating the surface of electroconductive particles, in order to inhibit aggregation of the metal, etc. Examples of the higher fatty acid include lauric acid, myristic acid, palmitic acid, stearic acid, oleic acid, linolic acid, linolenic acid, and lignoceric acid. Examples of the derivative of a higher fatty acid include metal salts of higher fatty acids, esters of higher fatty acids, and higher fatty acid amides.

The carboxylic acid(s) contained in the coating material may be a mixture of two or more of the carboxylic acids shown above. Preferred of the carboxylic acids enumerated above are the higher fatty acids which are saturated or unsaturated fatty acids having 12-24 carbon atoms.

For coating the surface of electroconductive particles with a coating material, a known method may be used, such as, for example, a method in which the two ingredients are stirred and kneaded in a mixer or a method in which the metal particles are impregnated with a solution of a carboxylic acid and the solvent is volatilized.

It is preferable that the electroconductive particles (A) are contained in an amount in the range of 50-99% by mass based on the whole adhesive composition. In case where the content of the electroconductive particles (A) is less than 50% by mass, it is difficult to control the cure shrinkage of the adhesive and, hence, the cured adhesive has reduced thermal conductivity and electrical conductivity and has impaired adhesiveness to the adherend. Conversely, in case where the content of the electroconductive particles (A) exceeds 99% by mass, it is difficult to make the adhesive composition pasty and the sufficient adhesiveness to adherends is impaired. The content of the electroconductive particles (A) is more preferably 60-95% by mass, even more preferably 70-95% by mass.

The electroconductive particles have an average particle diameter (D50) of preferably 1-10 µm, more preferably 2-6 µm. Although electroconductive particles having a particle diameter smaller than 1 µm are usable, size reduction to such a fine powder requires a high cost. Meanwhile, in case where the average particle diameter thereof exceeds 10 µm, it tends to be difficult to make the electroconductive adhesive pasty. The average particle diameter (D50) is calculated from a 50%-volume-cumulative particle diameter determined using a common particle size distribution analysis method such as a laser method or a sedimentation method. For example, the average particle diameter can be determined using laser diffraction/scattering type particle size distribution analyzer MT-3000, manufactured by Nikkiso Co., Ltd.

The adhesive composition of the invention contains a thermoplastic resin (B). It is preferred to use a powdery thermoplastic resin, and the powdery thermoplastic resin preferably is one which does not dissolve, or is less apt to dissolve, in the adhesive composition of the invention and which can retain the powder form. In the case of a thermoplastic resin which partly dissolves in the adhesive composition, it is preferable that at least 90% by mass of the thermoplastic resin remains undissolved. The term "powder form" herein means that the thermoplastic resin is in a particulate form having an average particle diameter (D50) of 1-100 µm. The average particle diameter (D50) thereof is preferably 1-20 µm. The average particle diameter (D50) is calculated from a 50%-volume-cumulative particle diameter determined using a common particle size distribution analysis method such as a laser method or a sedimentation method.

As the thermoplastic resin, use is made of a saturated ester resin. Only one of these resins may be used, or two or more thereof may be used in combination.

The ester resin to be used is not particularly limited so long as the resin has ester groups. Such an ester resin can be formed by a condensation reaction between one or more dihydroxy compounds selected from among aliphatic glycols such as ethylene glycol, propylene glycol, diethylene glycol, 1,4-butanediol, neopentyl glycol, and hexamethylene glycol, and alicyclic glycols such as cyclohexanedimethanol and one or more dicarboxylic acids selected from among aliphatic dicarboxylic acids such as oxalic acid, succinic acid, adipic acid, sebacic acid, and undecanedicarboxylic acid, and alicyclic dicarboxylic acids such as hexahydrodicarboxylic acid.

The ester resin can be formed also by the ring-opening polymerization of a lactide, which is a cyclic diester, or a lactone, which is a cyclic ester.

These ester resins may have been modified with another ingredient, e.g., an epoxy resin.

In the invention, the ester resins shown above are saturated ester resins. In particular, it is preferred to use a saturated polyester. Examples of the saturated polyester include the following commercial products: GV-110, GV-150, GV-158, GV-500, GV-550, GV-560, GV-570, GV-580, GV-990, GV-740, GV-741, GV-743, GV-746, GV-230, GV-235, GV-260, GV-350, and GV-351, manufactured by Japan U-pica Co., Ltd.; M-8010, M-8020, M-8021, M-8023, M-8051, M-8076, M-8100, M-8230, M-8240, M-8250, M-8842, M-8843, M-8860, M-8630, M-8961, M-8962, and M-8964, manufactured by DIC Corp.; and INNOVAX P, INNOVAX PD, INNOVAX SP, INNOVAX G, and INNOVAX PCM, manufactured by Shinto Paint Co., Ltd.

The saturated ester resins can be formed, for example, by a condensation reaction between a polyhydric alcohol and a polyvalent saturated aliphatic carboxylic acid.

The ester resin may have a glass transition point of 50-100°C. The glass transition point thereof is preferably 60-90°C, most suitably 70-80°C.

The ester resin may have a softening point of 100-150°C. The softening point thereof is preferably 110-140°C, most suitably 120-130°C.

The glass transition point and the softening point can be measured by general DSC.

It is preferable that the thermoplastic resin (B) is contained in an amount in the range of 5-20% by mass based on the whole adhesive composition. In case where the content of the thermoplastic resin (B) is less than 5% by mass, the adhesive composition has insufficient bonding strength, resulting in a decrease in connection reliability. Conversely, in case where the content thereof exceeds 20% by mass, the electroconductive particles are less apt to come into contact with one another, making it impossible to obtain electrical conductivity and thermal conductivity. The content of the thermoplastic resin (B) is more preferably 5-12% by mass, even more preferably 5-10% by mass.

The thermoplastic resin (B) may contain a hardener in a slight amount. The hardener is selected from among various hardeners in accordance with the kind of the thermoplastic resin. Examples thereof include tertiary amines, alkylureas, and imidazole.

The adhesive composition of the invention contains a nonpolar solvent (C). The inclusion of a nonpolar solvent in the adhesive composition of the invention is advantageous in that even when the thermoplastic resin (B) contains a hardener, this hardener can be inhibited from dissolving away to become activated and from causing the curing of the resin to proceed.

The nonpolar solvent having such a function can be suitably selected, in accordance with purposes, from among aliphatic hydrocarbons and aromatic hydrocarbons. Examples of the aliphatic hydrocarbons include paraffins. Examples of the aromatic hydrocarbons include benzene, naphthalene, and the like into which a fat-soluble substituent, such as an aliphatic hydrocarbon, has been introduced. Paraffins, the aromatic hydrocarbons, and the like are preferred of these from the standpoints of solvent volatility and the dispersibility of powdery ingredients.

Examples of commercial products of nonpolar solvents include BAB (alkylbenzenes), manufactured by FORMOSAN UNION CHEMICAL CORP., and Normal Paraffin H, manufactured by JXTG Nippon Oil & Energy Corp. One of these solvents may be used alone, or two or more thereof may be used in combination.

Nonpolar solvents having a relative permittivity of 4 or less are preferred, and ones having a relative permittivity of 3 or less are more preferred.

It is preferable that the nonpolar solvent (C) is contained in an amount in the range of 5-15% by mass based on the whole adhesive composition. In case where the content of the nonpolar solvent is less than 5% by mass, it is difficult to make the adhesive composition pasty and the silver powder and resinous ingredient are difficult to disperse, resulting in an uneven composition having reduced adhesiveness to adherends. Conversely, in case where the content thereof exceeds 15% by mass, the cured adhesive composition is prone to contain voids in a portion thereof in contact with the adherend and there is a possibility that this cured adhesive composition might have reduced adhesiveness and reduced thermal and electrical conductivity. The content of the nonpolar solvent is more preferably 8-10% by mass.

The adhesive composition of the invention contains a water-insoluble fluorochemical surfactant (D). Due to the inclusion of a water-insoluble fluorochemical surfactant in the adhesive composition of the invention, the substrate-wetting properties of the adhesive composition of the invention can be controlled. As a result, bleeding-out after bonding can be inhibited. This is thought to be because fluorinated groups of the water-insoluble fluorochemical surfactant are located on the surface of the adhesive composition to thereby make the adhesive composition have reduced surface energy. The term "water-insoluble" means that the fluorochemical surfactant, when mixed with the same volume of pure water, gives a mixture which, in an environment of, for example, 1 atm and 20°C, does not have an even appearance and separates into two layers.

Since the fluorochemical surfactant is water-insoluble, this fluorochemical surfactant can be compatible with the nonpolar solvent (C).

The adhesive composition of the invention is made to have a fluorine content of 40 mass ppm or higher by regulating the kind or amount of the water-insoluble fluorochemical surfactant (D). The fluorine content therein is preferably 100 mass ppm or higher. The fluorine content in the adhesive composition is preferably 1,000 mass ppm or less, more preferably 500 mass ppm or less.

Examples of the water-insoluble fluorochemical surfactant (D) include ethylene oxide adducts having a perfluoroalkyl group (perfluoroalkyl ethylene oxide compounds) and oligomer compounds having a perfluoroalkyl group.

The perfluoroalkyl ethylene oxide compounds have a structure represented by CₓF₂ₓ₊₁-(CH₂)_{y}-(OCH₂CH₂)_{z}-OH. Symbol x indicates the chain length of the perfluoroalkyl group, and is usually 1-20. Symbol y indicates the chain length of the alkylene group, and is usually 1-20. Symbol z indicates the number of ethylene oxide groups, and is usually 1-50. As a perfluoroalkyl ethylene oxide compound which is water-insoluble and has that structure, use can be made, for example, of S-420, manufactured by Surflon.

The oligomer compounds having a perfluoroalkyl group are not particularly limited so long as the compounds are oligomer compounds having a perfluoroalkyl group as the name implies. As an oligomer compound which is water-insoluble and has a perfluoroalkyl group, use can be made, for example, of S-651.

The water-insoluble fluorochemical surfactant (D) in the invention has a fluorine content of preferably 20-70%, more preferably 30-60%, even more preferably 40-50%. In cases when the fluorochemical surfactant has a fluorine content within that range, this fluorochemical surfactant can be added in a reduced amount and does not considerably change the properties of the electroconductive adhesive. Consequently, the bleeding-out phenomenon can be more effectively inhibited.

It is preferable that the water-insoluble fluorochemical surfactant (D) has a 0.5%-concentration surface tension (mN/m) of 20.0 or higher. The 0.5%-concentration surface tension thereof is more preferably 21.0 or higher, more preferably 22.0 or higher. The 0.5%-concentration surface tension is the surface tension of a mixture obtained by adding 0.5% the fluorochemical surfactant (D) to a solvent. The reason for the surface tension is that this fluorochemical surfactant can reduce the surface energy even when added in a small amount. Examples of the solvent include ethyl acetate, toluene, PGMEA (propylene glycol mono methyl ether acetate), and MEK (methyl ethyl ketone).

It is preferable that the water-insoluble fluorochemical surfactant (D) is contained in an amount in the range of 0.001-1.0% by mass based on the whole adhesive composition. In case where the content of the water-insoluble fluorochemical surfactant is less than 0.001% by mass, sufficient surface tension is not obtained and bleeding-out is prone to occur. Conversely, in case where the content thereof exceeds 1.0% by mass, a decrease in bonding strength results. The content of the water-insoluble fluorochemical surfactant is more preferably 0.01-0.1% by mass.

The adhesive composition of the invention may contain, for example, a hardener besides the ingredients described above. Examples of the hardener include tertiary amines, alkylureas, and imidazole.

It is preferable that the hardener is contained in an amount in the range of 1.0-10.0% by mass based on the whole adhesive composition. In case where the content of the hardener is less than 1.0% by mass, the adhesive composition may cure insufficiently to have poor heat resistance. Conversely, in case where the content thereof exceeds 10.0% by mass, there is a possibility that some of the hardener might remain unreacted to reduce the adhesiveness to the adherend, resulting in a decrease in electrical property.

A hardening accelerator can be incorporated into the adhesive composition of the invention. Examples of the hardening accelerator include imidazole compounds such as 2-phenyl-4,5-dihydroxymethylimidazole, 2-phenyl-4-methyl-5-hydroxymethylimidazole, 2-methyl-4-methylimidazole, and 1-cyano-2-ethyl-4-methylimidazole, tertiary amines, triphenylphosphine and analogues thereof, urea compounds, phenols, alcohols, and carboxylic acids. Only one hardening accelerator may be used, or two or more hardening accelerators may be used in combination.

The amount of the hardening accelerator to be incorporated is not particularly limited, and may be suitably determined. However, in the case of using a hardening accelerator, the amount thereof is generally 0.1-2.0% by mass based on the whole adhesive composition of the invention.

Other additives can be suitably incorporated into the adhesive composition of the invention so long as the effect of the invention is not lessened thereby. The other additives include antioxidants, ultraviolet absorbers, tackifiers, viscosity modifiers, dispersants, coupling agents, toughening agents, elastomers, etc.

It is preferable that the content of any polar solvent in the adhesive composition of the invention is minimized. This is because in case where the adhesive composition contains a polar solvent, some of the resin in the composition dissolves and this is prone to result in a barrier film. The content of any polar solvent in the adhesive composition of the invention is preferably 1% by mass or less, more preferably 0.1% by mass or less. Evan more preferably, the composition contains substantially no polar solvent. The expression "containing substantially no polar solvent" means that the polar-solvent content is less than 0.05% by mass based on the whole adhesive composition of the invention.

The adhesive composition of the invention can be obtained by mixing and stirring the ingredient (A), ingredient (B), ingredient (C), and ingredient (D) described above and other ingredients in any desired sequence. For dispersing the ingredients, use can be made of a method employing, for example, a two-roll mill, three-roll mill, sand mill, roll mill, ball mill, colloid mill, jet mill, bead mill, kneader, homogenizer, propeller-less mixer, or the like.

The viscosity of the thus-prepared adhesive composition from which the electroconductive particles (A) have been removed is measured with a rotational viscometer. In the present invention, the viscosity is measured at a temperature of 25°C with a spindle type viscometer, as a rational viscometer, employing SC4-14 spindle at specific rotational speeds (rpm).

It is preferable that the adhesive composition prepared in the manner described above has a TI value (thixotropy index) of 2-4, the TI value being calculated from viscosity values measured by examining the adhesive composition from which the electroconductive particles (A) have been removed, with the rotational viscometer at rotational speeds of 10 rpm and 50 rpm. In cases when the adhesive composition from which the electroconductive particles (A) have been removed has such TI value, not only an operation of paste production can be conducted with higher efficiency but also the adhesive composition shows improved applicability in an application step. In the present invention, the TI value is calculated by dividing a value measured with the rotational viscometer at a rotational speed of 10 rpm by a value measured therewith at a rotational speed of 50 rpm.

The bleeding-out properties of the adhesive composition of the invention can be evaluated, for example, by the following method. First, 5.0 g of the adhesive composition of the invention is packed into a 5-cc syringe and applied, using a dispenser, to a copper frame of a silver-plated copper frame so as to form ten dots of the adhesive composition each weighing 0.15 mg. Next, using a microscope or the like, the dimension of the width (µm) ranging from the periphery of each circle of the applied adhesive to the periphery of the bleedout is measured. The measurement is made, for example, (1) immediately after the application (after 0 hour) or (2) at two hours after the application.

In the case of the silver-plated copper frame, the width of the bleedout measured by that method is preferably less than 200 µm, more preferably less than 170 µm, even more preferably less than 100 µm, most preferably less than 70 µm. In the case of the copper frame, the width thereof is preferably less than 300 µm, more preferably less than 200 µm, even more preferably less than 100 µm.

### Examples

The present invention is explained below in more detail by reference to Examples, but the present invention should not be construed as being limited by the following Examples in any way.

### [Examples 1 to 8 and Comparative Examples 1 to 6]

### A. Preparation of Adhesive Compositions

The materials shown in Table 1 were kneaded with a three-roll mill and a homogenizer to prepare adhesive compositions respectively having the makeups shown in Table 1. (The numerals for each material indicate amounts in % by mass based on the whole mass of the respective adhesive compositions.) The materials used are as follows. The sequence of kneading was: (C) nonpolar solvent, (B) ester resin, (A) electroconductive particles, and (D) fluorochemical surfactant. Each adhesive composition was heated at 200°C for 1 hour and then allowed to cool to room temperature to obtain a cured object of the adhesive composition.

### (A) Electroconductive Particles

As electroconductive particles, use was made of a silver powder obtained by mixing a flaky silver powder having an average particle diameter (D50) of 3 µm manufactured by Tanaka Kikinzoku Kogyo K.K. and a flaky silver powder having an average particle diameter (D50) of 6 µm manufactured by Tanaka Kikinzoku Kogyo K.K., in a ratio of 1:1.

### (B) Thermoplastic Resin

As a thermoplastic resin, use was made of a powdery saturated-ester resin (glass transition point, 70-80°C; softening point, 120-130°C) manufactured by Tanaka Kikinzoku Kogyo K.K. With respect to the size of the resin, the average particle diameter (D50) thereof was 10 µm. The thermoplastic resin used was ascertained to be undissolved in each adhesive composition and present in the powdery state.

### (C) Nonpolar Solvent

As a nonpolar solvent, use was made of a solvent obtained by mixing BAB (alkylbenzenes), manufactured by FORMOSAN UNION CHEMICAL CORP., and Normal Paraffin H, manufactured by JXTG Nippon Oil & Energy Corp., in a ratio of 1:1.

### (D) Water-insoluble Fluorochemical Surfactants

- Perfluoroalkyl ethylene oxide compound [Surflon S420; AGC Sei Chemical Co., Ltd.]; fluorine content, 47%; 0.5%-concentration surface tension in ethyl acetate (mN/m), 23.1
- Oligomer compound having perfluoroalkyl group [Surflon S651; AGC Sei Chemical Co., Ltd.]; fluorine content, 23%; 0.5%-concentration surface tension (mN/m), 23.0
- Oligomer compound having perfluoroalkyl group [Surflon S611; AGC Sei Chemical Co., Ltd.]; fluorine content, 10%; 0.5%-concentration surface tension in ethyl acetate (mN/m), 18.4

The fluorine content of each of the fluorochemical surfactants was determined by ion chromatography.

### (Non-fluorochemical Surfactants)

In Comparative Examples, the following non-fluorochemical surfactants were used in place of the water-insoluble fluorochemical surfactants.
- Antox EDH-400, manufactured by Nippon Nyukazai Co., Ltd. (Comparative Example 2)
- Newcol 2609, manufactured by Nippon Nyukazai Co., Ltd. (Comparative Example 3)
- Newcol 565-PS, manufactured by Nippon Nyukazai Co., Ltd. (Comparative Example 4) AMIET 320, Kao Corp. (Comparative Example 5)
- HOMOGENOL L-95, Kao Corp. (Comparative Example 6)

### B. Property Evaluation of the Adhesive Compositions

### 1. Bleeding-out Property

First, 5.0 g of each sample was packed into a 5-cc Musashi syringe and applied to a copper frame or a silver-plated copper frame using a dispenser so as to form ten dots of the sample each weighing 0.15 mg.

Using microscope STM7, manufactured by Olympus Co., Ltd., the dots were examined for bleeding-out under the following conditions (1) and (2).
(1) immediately after application (after 0 hour)
(2) at two hours after application

In the examination, the dimension of the width (µm) ranging from the periphery of each circle of the applied adhesive to the periphery of the bleedout was measured. With respect to each dot, the measurement was made on four portions, i.e., upper, lower, left-hand, and right-hand portions.

### [Evaluation]

An average value of bleedout dimension was determined for each sample for each set of conditions, and each sample was evaluated in accordance with the following criteria. Symbol ○ indicates that the bleeding-out inhibitory effect is excellent, Δ indicates that said effect is good, and × indicates that said effect is poor.

### Silver-plated copper frame

○_{:} bleedout, less than 100 µm
Δ: bleedout, 100 µm or larger but less than 200 µm
×: bleedout, 200 µm or larger

### Copper frame

○_{:} bleedout, less than 100 µm
Δ: bleedout, 100 µm or larger but less than 300 µm
×: bleedout, 300 µm or larger

Each of the adhesive compositions of the Examples and Comparative Examples was evaluated for a total of four items under the conditions (1) and (2), the order of evaluation priority being ×>Δ>○. The results of evaluation with higher priority are shown in Table 1 as overall evaluation.

### 2. Evaluation of Electrical Conductivity

The adhesive compositions prepared above were each applied on a glass substrate, which had been masked with a transparent PET sheet tape manufactured by Nichiei Kakoh Co., Ltd., by stencil printing in a pattern having a width of 0.5 mm and a length of 60 mm. This glass substrate was placed in an oven and the applied adhesive composition was cured under the conditions of 200°C and 60 minutes. Thereafter, the glass substrate was cooled to room temperature, and terminals were brought into contact with both ends of a 5-cm-long section of the cured film to measure the resistance. The thickness of the cured film was also measured. The volume resistivity was calculated from the measured resistance value and film thickness to evaluate the electrical conductivity (µΩ·cm). The resistance of the cured film was measured with M-Ohm HiTESTER 3540, manufactured by Hioki E.E. Corp. The thickness of the cured film was measured with surface roughness meter Surfcorder SE-30H, manufactured by Kosaka Laboratory Ltd. The results are shown in Table 1.

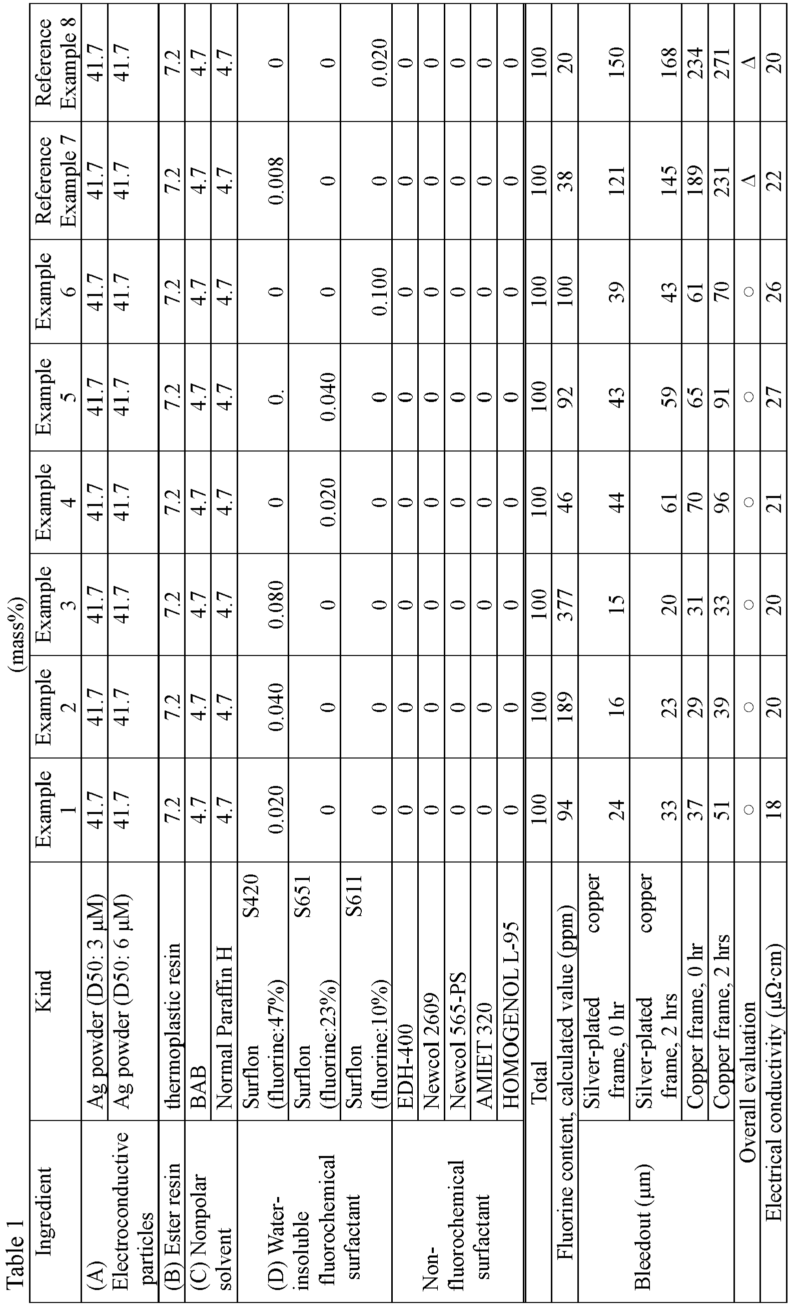

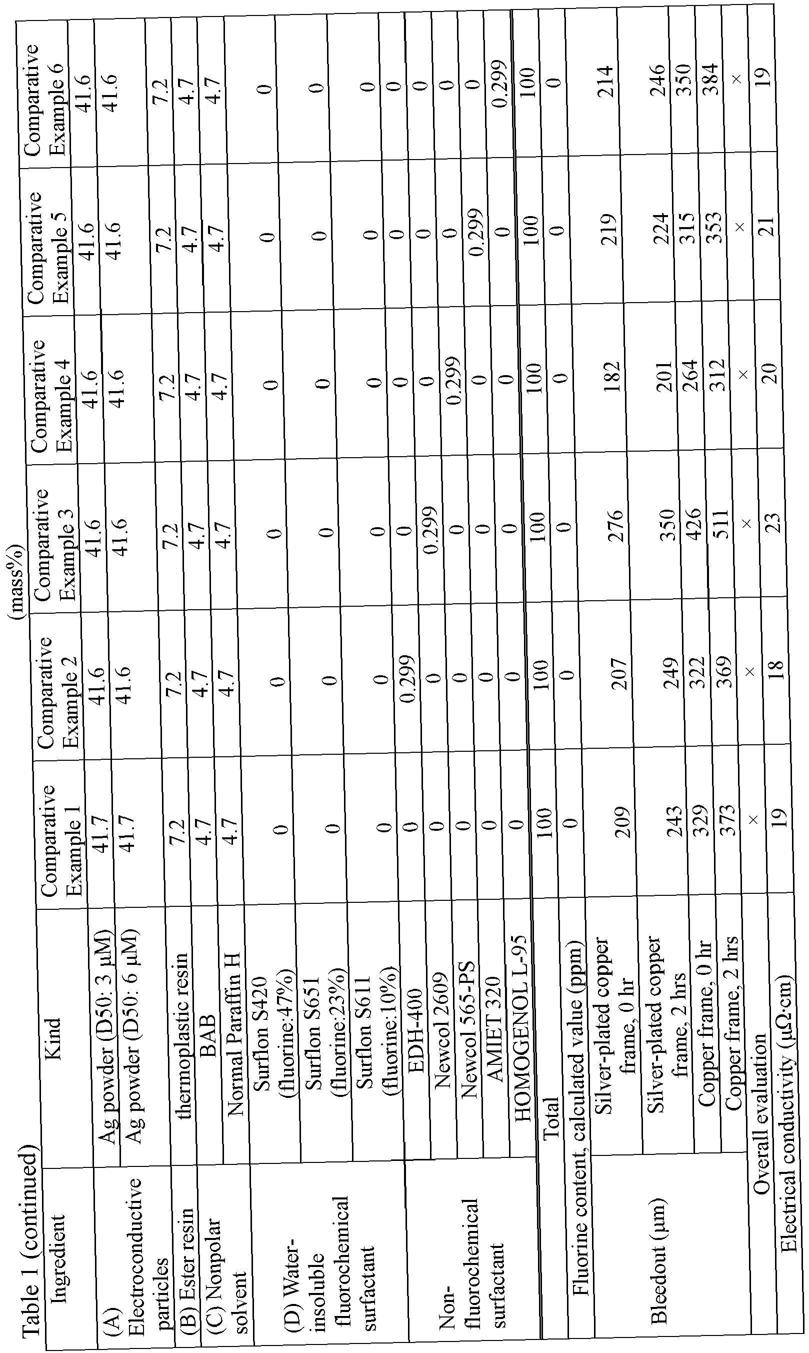

As the results in the table show, the electroconductive adhesive compositions of the invention retained satisfactory electrical conductivity and were inhibited from suffering bleeding-out, due to the inclusion of a water-insoluble fluorochemical surfactant. In particular, Examples 1 to 6, which each had a fluorine content of 40 ppm or higher, were found to be remarkably inhibited from suffering bleeding-out.

## Claims

1. An electroconductive adhesive composition comprising: (A) electroconductive particles; (B) a thermoplastic resin; (C) a nonpolar solvent; and (D) a water-insoluble fluorochemical surfactant, wherein
the electroconductive adhesive composition contains fluorine in an amount of at least 40 mass ppm of the whole electroconductive adhesive composition,
the thermoplastic resin (B) is a saturated ester resin, and
the nonpolar solvent (C) comprises one or more aliphatic or aromatic hydrocarbons.

2. The electroconductive adhesive composition according to claim 1, wherein the water-insoluble fluorochemical surfactant (D) has a fluorine content of 20-70% by mass.

3. The electroconductive adhesive composition according to claim 1 or 2, wherein the water-insoluble fluorochemical surfactant (D) is a fluorochemical surfactant having a perfluoroalkyl group.

4. The electroconductive adhesive composition according to any one of claims 1 to 3, wherein the water-insoluble fluorochemical surfactant (D) is an ethylene oxide adduct having a perfluoroalkyl group.

5. The electroconductive adhesive composition according to any one of claims 1 to 4, wherein the water-insoluble fluorochemical surfactant (D) is an oligomer compound having a perfluoroalkyl group.

6. The electroconductive adhesive composition according to any one of claims 1 to 5, wherein the electroconductive particles (A) are powdery metallic particles comprising Ag or Cu as a main component.

## Patentansprüche

1. Elektrisch leitfähige Klebstoffzusammensetzung, umfassend: (A) elektrisch leitfähige Partikel, (B) ein thermoplastisches Harz, (C) ein nicht-polares Lösungsmittel und (D) ein wasserunlösliches fluorchemisches Tensid, wobei
die elektrisch leitfähige Klebstoffzusammensetzung Fluor in einer Menge von mindestens 40 Masse-ppm der gesamten elektrisch leitfähigen Klebstoffzusammensetzung enthält,
das thermoplastische Harz (B) ein gesättigtes Esterharz ist und
das nicht-polare Lösungsmittel (C) einen oder mehrere aliphatische oder aromatische Kohlenwasserstoffe umfasst.

2. Elektrisch leitfähige Klebstoffzusammensetzung gemäß Anspruch 1, wobei das wasserunlösliche fluorchemische Tensid (D) einen Fluorgehalt von 20-70 Masse-% aufweist.

3. Elektrisch leitfähige Klebstoffzusammensetzung gemäß Anspruch 1 oder 2, wobei das wasserunlösliche fluorchemische Tensid (D) ein fluorchemisches Tensid mit einer Perfluoralkylgruppe ist.

4. Elektrisch leitfähige Klebstoffzusammensetzung gemäß irgendeinem der Ansprüche 1 bis 3, wobei das wasserunlösliche fluorchemische Tensid (D) ein Ethylenoxid-Addukt mit einer Perfluoralkylgruppe ist.

5. Elektrisch leitfähige Klebstoffzusammensetzung gemäß irgendeinem der Ansprüche 1 bis 4, wobei das wasserunlösliche fluorchemische Tensid (D) eine Oligomerverbindung mit einer Perfluoralkylgruppe ist.

6. Elektrisch leitfähige Klebstoffzusammensetzung gemäß irgendeinem der Ansprüche 1 bis 5, wobei die elektrisch leitfähigen Partikel (A) pulverförmige metallische Partikel sind, die Ag oder Cu als Hauptkomponente umfassen.

## Revendications

1. Composition adhésive électroconductrice comprenant : (A) des particules électroconductrices ; (B) une résine thermoplastique ; (C) un solvant non polaire ; et (D) un tensioactif fluoré insoluble dans l'eau, dans laquelle
la composition adhésive électroconductrice contient du fluor dans une quantité d'au moins 40 ppm en masse de la composition adhésive électroconductrice totale,
la résine thermoplastique (B) est une résine d'ester saturé, et
le solvant non polaire (C) comprend un ou plusieurs hydrocarbures aliphatiques ou aromatiques.

2. Composition adhésive électroconductrice selon la revendication 1, dans laquelle le tensioactif fluoré insoluble dans l'eau (D) présente une teneur en fluor de 20 à 70 % en masse.

3. Composition adhésive électroconductrice selon la revendication 1 ou 2, dans laquelle le tensioactif fluoré insoluble dans l'eau (D) est un tensioactif fluoré présentant un groupe perfluoroalkyle.

4. Composition adhésive électroconductrice selon l'une quelconque des revendications 1 à 3, dans laquelle le tensioactif fluoré insoluble dans l'eau (D) est un adduit d'oxyde d'éthylène présentant un groupe perfluoroalkyle.

5. Composition adhésive électroconductrice selon l'une quelconque des revendications 1 à 4, dans laquelle le tensioactif fluoré insoluble dans l'eau (D) est un composé oligomère présentant un groupe perfluoroalkyle.

6. Composition adhésive électroconductrice selon l'une quelconque des revendications 1 à 5, dans laquelle les particules électroconductrices (A) sont des particules métalliques en poudre comprenant Ag ou Cu comme composant principal.
